(19)

**Europäisches Patentamt**

**European Patent Office**

**Office européen des brevets**

(11) **EP 4 361 877 A1**

(12) **EUROPEAN PATENT APPLICATION**

(43) Date of publication:
01.05.2024 Bulletin 2024/18

(21) Application number: 22204472.9

(22) Date of filing: 28.10.2022

(51) International Patent Classification (IPC):
$G06F\ 30/20^{(2020.01)}$ $G06F\ 11/36^{(2006.01)}$

(52) Cooperative Patent Classification (CPC):
G06F 30/20; G06F 11/3664; G06F 11/3684

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Aptiv Technologies AG 8200 Schaffhausen (CH)**

(72) Inventors:
• **Turlej, Wojciech 30-349 Krakow (PL)**
• **Pankiewicz, Nikodem 30-653 Kraków (PL)**
• **Orlowski, Mateusz 30-817 Kraków (PL)**

(74) Representative: **Manitz Finsterwald Patent- und Rechtsanwaltspartnerschaft mbB Martin-Greif-Strasse 1 80336 München (DE)**

(54) **METHODS AND SYSTEMS FOR GENERATING TRAJECTORY INFORMATION OF A PLURALITY OF ROAD USERS**

(57)     A computer implemented method for generating trajectory information of a plurality of road users comprises the following steps carried out by computer hardware components: determining a cost function which maps the trajectory information of the plurality of road users to a cost value; determining a side constraint function which maps the trajectory information of the plurality of road users to a side constraint value; and solving an optimization problem for the trajectory information based on the cost function and based on the side constraint function.

EP 4 361 877 A1

## Description

FIELD

The present disclosure relates to methods and systems for generating trajectory information of a plurality of road users.

BACKGROUND

Scenarios of driving situations may be used in various applications. However, it may be cumbersome to obtain such scenarios.

Accordingly, there is a need to provide scenarios of driving situations in an efficient and effective way.

SUMMARY

The present disclosure provides a computer implemented method, a computer system and a non-transitory computer readable medium according to the independent claims. Embodiments are given in the subclaims, the description and the drawings.

In one aspect, the present disclosure is directed at a computer implemented method for generating trajectory information of a plurality of road users, the method comprising the following steps performed (in other words: carried out) by computer hardware components: determining a cost function which maps the trajectory information of the plurality of road users to a cost value; determining a side constraint function which maps the trajectory information of the plurality of road users to a side constraint value; and solving an optimization problem for the trajectory information based on the cost function and based on the side constraint function. The trajectory information of the plurality of road users comprises a plurality of parameters, wherein the plurality of parameters define a respective actual trajectory for each road user of the plurality of road users and a respective observed trajectory for each road user of the plurality of road users, wherein the respective observed trajectory for each road user of the plurality of road users represents the respective actual trajectory for each road user of the plurality of road users as observed by a sensor; and the cost function and/ or the side constraint function comprises a term based on both the actual trajectory or trajectories for at least one road user of the plurality of road users and the corresponding observed trajectory or trajectories for the at least one road user of the plurality of road users.

In other words, a scenario may be obtained based on solving an optimization problem. The scenario may be defined by a plurality of parameters. The parameters may represent trajectories of other road users and a representation of how these trajectories are observed or perceived, for example by an ego vehicle.

The road users may include vehicles, such as cars, trucks, lorries, busses, motorbikes, or bicycles, or pedestrians, or even animals on the road.

With the method according to various embodiments, adversarial trajectories generation may be provided. The adversarial trajectories may be trajectories which lead to (or which represent) critical driving situations. Such situations may be difficult to obtain based on measurements (since they may involve an actual accident).

As described herein, trajectories of all the road users (except the ego-vehicle) may be optimized in a SIL (software in the loop) environment with cost terms/constraints that promote/enforce finding scenarios that end up with a collision with an ego.

The side constraint function, which may be referred to as side constraints or constraints for short, may for example include one or more terms based on physical limitations of road users (for example speed constraints or acceleration constraints), and/ or one or more terms related to an end position of one of the road users overlapping with the ego vehicles end position (which may equate to a collision).

The cost function may include one or more term related to at least one of the following: severity (for example minimum time to collision, distance, safety rules violations), plausibility (for example parametrized rules regarding typical accelerations), dissimilarity to already generated scenarios, and/ or related to the observed trajectory being close to the actual trajectory.

The observed trajectory may also be referred to as perceived trajectory. It will be understood that the "actual trajectory" refers to an assumption of an actual trajectory of a road user (in contrast to the observed trajectory), but may not necessarily be related to a trajectory that a real-life road user actually takes or took; in other words: it may not be required to perform real-life measurements in order to determine the actual trajectory, but rather, the actual trajectory is a result of solving the optimization problem.

According to an embodiment, the optimization problem is solved iteratively. This may provide for efficiency. Furthermore, by applying an iterative method, the accuracy of the obtained trajectory information as the optimization result, may be selectively be higher (with potentially a higher number of iterations) or lower (with potentially a lower number of iterations). For some applications, higher accuracy may be required, while for other applications, lower accuracy may be sufficient.

According to an embodiment, an initial trajectory information for the optimization problem is determined randomly. The initial trajectory may include random values, or the initial trajectory may include values which are based on previously obtained trajectory information to which random values may be added.

According to an embodiment, the optimization problem is solved based on a gradient-free stochastic method, preferably a particle swarm optimization method or a covariance matrix adaptation evolution method. It has been found that these methods reliably and efficiently provide good results.

According to an embodiment, the parameters further comprise static environment parameters. The static environment parameters may include parameters related to one or more static other road users standing still and/or objects, in particular only static environment parameters.

According to an embodiment, wherein the cost function and/ or the side constraint function is based on a severity of a scenario represented by the trajectory information. The severity may indicate how dangerous the scenario is. Employing a severity of a scenario in the optimization problem may ensure generation of only interesting, high-risk scenarios. The severity of the scenario may be determined based on heuristics, such as for example based on time to collision (TTC), distance, or headway. The severity of the scenario may be taken into account by using a set of constraints which explicitly enforces collision.

According to an embodiment, the cost function and/ or the side constraint function is based on a plausibility of a scenario represented by the trajectory information. Employing a plausibility of a scenario may prevent unrealistic scenarios. Plausibility may include parametrized rules (for example penalty for accelerating of road users towards an ego vehicle in its proximity), and/ or rules based on real-life data to reflect typical road situations. With sufficient plausibility estimation, an inequality constraint may be set to fit in the system's acceptable risk level.

According to an embodiment, wherein the cost function and/ or the side constraint function is based on a novelty of a scenario represented by the trajectory information. Novelty may refer to novelty within a database. The database may store trajectory information obtained from solving various different optimization problems. Employing novelty may prevents repetition, and may help to create wide variety of scenarios. For example, novelty may be determined based on a weighted sum of state variables (or parameters) differences integrals over time. A randomized initial state, for example an initial trajectory information for the optimization problem which is determined randomly, may help to explore variety of local optima.

According to an embodiment, the cost function and/ or the side constraint function comprises a term related to a desired output of a scenario represented by the trajectory information. This may allow the optimization problem to find a solution (an optimal trajectory information) which is close to a desired scenario.

According to an embodiment, a machine-learning model, for example an artificial neural network, for driving assistance may be trained based on the trajectory information. It has been found that using the trajectory information (which is the solution to the optimization problem) leads to good training results.

According to an embodiment, a machine-learning model, for example an artificial neural network, for driving assistance may be tested based on the trajectory information. It has been found that using the trajectory information (which is the solution to the optimization problem) leads to reliable testing results.

According to an embodiment, the training and/ or the testing comprises evaluating a driving policy for an at least partially autonomous vehicle. It has been found that using the trajectory information (which is the solution to the optimization problem) leads to reliable evaluation results.

According to an embodiment, the driving policy acts based on observed trajectories for the plurality of road users; and the driving policy is evaluated based on actual trajectories for the plurality of road users. This may reflect the case in real life where the other road users move according to specific trajectories (which in the method according to various embodiments are represented by the actual trajectories), but the ego vehicle makes decisions according to the policy based on the data that the ego vehicle acquires by its sensors (which in the method according to various embodiments is represented by the observed trajectory).

In another aspect, the present disclosure is directed at a computer system, said computer system comprising a plurality of computer hardware components configured to carry out several or all steps of the computer implemented method described herein. The computer system can be part of a vehicle.

The computer system may comprise a plurality of computer hardware components (for example a processor, for example processing unit or processing network, at least one memory, for example memory unit or memory network, and at least one non-transitory data storage). It will be understood that further computer hardware components may be provided and used for carrying out steps of the computer implemented method in the computer system. The non-transitory data storage and/or the memory unit may comprise a computer program for instructing the computer to perform several or all steps or aspects of the computer implemented method described herein, for example using the processing unit and the at least one memory unit.

In another aspect, the present disclosure is directed at a non-transitory computer readable medium comprising instructions which, when executed by a computer, cause the computer to carry out several or all steps or aspects of the computer implemented method described herein. The computer readable medium may be configured as: an optical medium, such as a compact disc (CD) or a digital versatile disk (DVD); a magnetic medium, such as a hard disk drive (HDD); a solid state drive (SSD); a read only memory (ROM), such as a flash memory; or the like. Furthermore, the computer readable medium may be configured as a data storage that is accessible via a data connection, such as an internet connection. The computer readable medium may, for example, be an online data repository or a cloud storage.

The present disclosure is also directed at a computer program for instructing a computer to perform several or all steps or aspects of the computer implemented method described herein.

DRAWINGS

Exemplary embodiments and functions of the present disclosure are described herein in conjunction with the following drawings, showing schematically:

Fig. 1 an illustration of a traffic scenario according to various embodiments; and

Fig. 2 an illustration of generating an adversarial scenario according to various embodiments;

Fig. 3 illustration of a definition of state estimation error according to various embodiments;

Fig. 4 a flow diagram illustrating a method for generating trajectory information of a plurality of road users according to various embodiments; and

Fig. 5 a computer system with a plurality of computer hardware components configured to carry out steps of a computer implemented method for generating trajectory information of a plurality of road users according to various embodiments.

DETAILED DESCRIPTION

Scenarios of driving situations may be used in various applications. However, it may be cumbersome to obtain such scenarios.

Testing and validation may be expensive and time-consuming part of Advanced Driver Assistance Systems (ADAS) and Autonomous Driving (AD) systems development. A goal of testing and validation may be to ensure that system will perform well in critical, atypical scenarios, for instance in presence of erratic drivers.

Exploration of such cases in the real-world drives may require gathering an extensively large amount of data at a high cost. A commonly proposed alternative may be to utilize simulated test drives. While simulation may reduce the cost of data acquisition, it may not be able to generate atypical scenarios (e.g. arising due to drivers' tiredness, distraction, drug/alcohol influence).

According to various embodiments, scenarios of driving situations may be provided in an efficient and effective way.

Typical traffic scenarios may be obtained from real-world drives or simulated drives. Similarly, critical traffic scenarios may be generated as test track scenarios or from simulated test cases. However, edge case scenarios (for example scenarios that will lead to an accident) may require adversarial trajectory generation, which usually involves large scale simulation.

However, it may be cumbersome to find scenarios that are difficult for tested AD (Autonomous Driving) /ADAS (Advanced Driver Assistance Systems (ADAS) methods.

Since test drives (both real world and simulation-based) may gather data mostly about typical traffic scenarios, this may be an inefficient way of finding flaws in the tested method (i.e. the method to be tested). According to various embodiments, finding gaps in a particular method may be found and thus may uncover well-hidden weak points of the system.

Both simulated and real-world test drives explore critical scenarios in a very ineffective way -relying on assumption that they will appear during the drive "by chance". In contrast, according to various embodiments, it may be focused solely on critical test cases by attempting to purposefully simulate viable situations which end up with collisions or other dangerous incidents. According to various embodiments, such scenarios may be explored by optimization-based trajectory generation.

According to various embodiments, collisions or critical situations may intentionally be triggered in a SIL (software in the loop) /HIL (hardware in the loop) setup in order to efficiently find as many flaws in the tested method as possible.

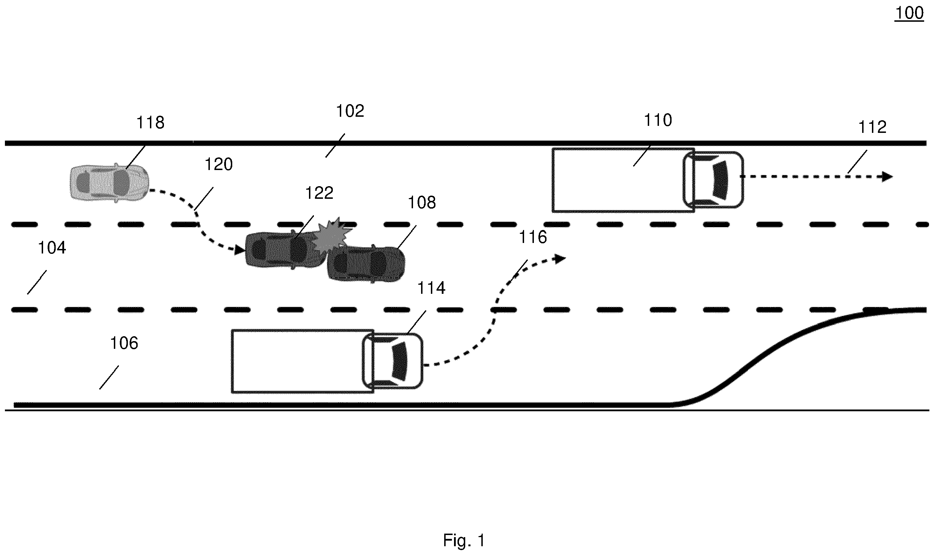

Fig. 1 shows an illustration 100 of a traffic scenario according to various embodiments. An ego vehicle 108 may be driving on a road, which may for example include a left lane 102, a middle lane 104, and a right lane 106. The ego vehicle 108 may drive on the middle lane 104. A first truck 110 may drive along a trajectory 112. A second truck 114 may drive along a trajectory 116. Another car 118 may drive along a trajectory 120. The trajectory 120 of the other car 118 may be such that an accident with the other car 118 and the ego vehicle 108 occurs, as illustrated in 122. The trajectories, as illustrated in Fig. 1, may be trajectories in a world coordinate system. However, it will be understood that trajectories may also be considered in a vehicle coordinate system of the ego vehicle 108.

According to various embodiments, such critical scenarios may be generated through optimization of adversarial trajectories.

Critical scenarios generated with methods according to various embodiments may provide a good understanding of the system's weak spots, and may help finding issues in the product and guide development. It's worth noticing that the cycle of exploring and addressing possible issues is also a central focus of ISO/PAS 21448 (SOTIF; Safety Of The Intended Functionality) standard.

Automatic generation of difficult test scenarios according to various embodiments, for example for Autonomous Driving (AD) and Advanced Driver Assistance Systems (ADAS), may allow to find potential issues in the system without extreme testing efforts. Automatic test cases generation may be performed through optimization of road users' trajectories in a surrounding of the ego vehicle controlled by the tested method in a simulation environment. The optimization problem may be formulated in a way that promotes finding trajectories, that result in collisions or near-miss situations (e.g., low Time to Collision (TTC) events).

Automatic generation of test cases according to various embodiments may expose possible weaknesses or issues in the vehicle control methods and may be used to improve system's robustness to difficult situations, e.g. by including the generated test scenarios in the scenarios set used for training the Reinforcement-Learning-based driving policies.

Utilization of such techniques may be especially beneficial in validation of the systems based on machine learning techniques, as it may uncover issues that are otherwise difficult to predict due to a black-box nature of such algorithms.

According to various embodiments, by including the observed trajectory into consideration, risks related to potential perception system failures (e.g., false negative detections or state estimation errors) in the context of road situations may be captured.

According to various embodiments, perception trajectory may be generated, enabling exploration of safety-critical perception errors. Finding combinations of road scenarios with perception errors that may lead to collisions may be helpful in decreasing the collision probability achieved by ADAS/AD systems, allowing to both define more precise requirements for perception systems as well as train driving policies that would avoid situations in which small perception error may lead to catastrophic failure.

A state trajectory may denote a function that describes changes of vehicle's state (e.g. position, velocity) in time. A control trajectory may denote a function that describes changes of vehicle's control inputs (e.g. steering angle, throttle, brake) in time.

According to various embodiments, validation for AD and ADAS methods based on optimization-based trajectory generation may be provided. According to various embodiments, plausible critical scenarios may be found in which the ego vehicle which is controlled by the method under test cannot avoid collision. Trajectories of an arbitrary number of vehicles (or road users) surrounding the ego vehicle may be generated in order to trigger a collision event. Trajectory generation may be formulated as a continuous optimization problem with cost terms that promote finding solution that results in a collision of at least one of the other road users with the ego vehicle. Additional cost terms may be introduced in order to enable repeated execution of the method to derive various dissimilar scenarios in which collision is achieved and to assure that generated situations are plausible enough to be considered.

According to various embodiments, by AD and ADAS methods validation based on the optimized trajectories, robustness of the AD/ADAS system to perception errors in critical scenarios may be provided. According to various embodiments, a set of plausible road scenarios with corresponding plausible perception system's error patterns that result in collisions or near miss events in a simulation may be generated iteratively.

According to various embodiments, the trajectory generation task may be formulated as an optimization problem in which trajectories of one or more road users (for example vehicles, which may be referred to as adversary agents) in a proximity of the ego vehicle are optimized, while the ego vehicle's movement is governed by a driving policy that is subjected to the tests. The cost function of the optimization problem may reward an increase in the scenario's severity.

In order to generate plausible error patterns, for each adversary agent, an additional perception trajectory is generated, i.e., a function of the adversary agent's state as observed by ego vehicle's perception system in time (which may possibly be different from state trajectory due to perception system's state estimation errors).

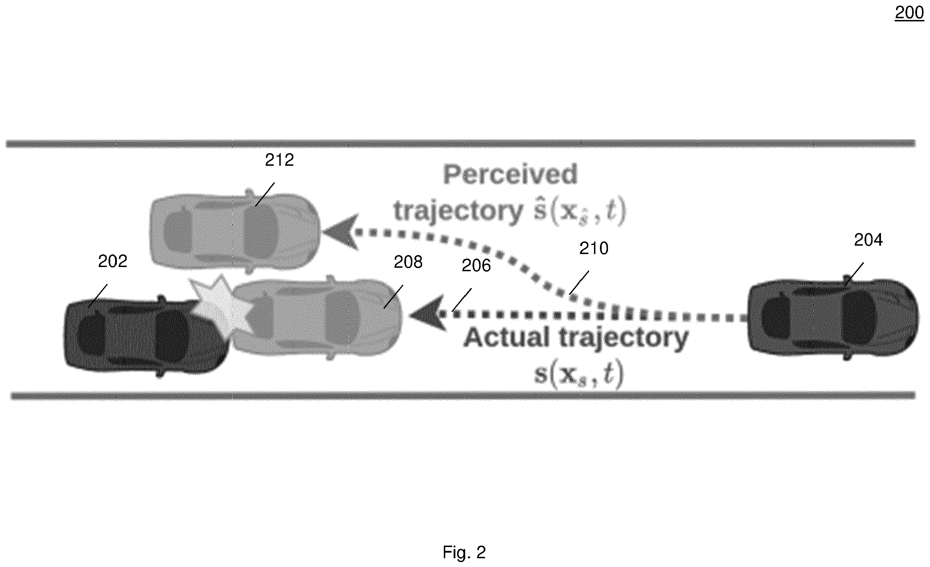

Fig. 2 shows an illustration 200 of generating an adversarial scenario according to various embodiments. An ego vehicle 202 and another car 204 may be driving on a road. According to various embodiments, the actual trajectory 206 of the other car 204 and the perceived trajectory 210 of the other car 204 are optimized simultaneously. The perceived trajectory 210 of the other car 204 may denotes an output of the state estimation for the other car 204 performed by the perception system of the ego vehicle 202. It will be understood that both the actual trajectory 206 and the perceived trajectory 210 are provided in a vehicle coordinate system of the ego vehicle 202, i.e. they are provided relative to the ego vehicle 202. In the illustrated example, the tested driving policy of the ego vehicle 202 fails to perform an evasive maneuver due to perception error, which results in a collision with the other vehicle 204. As shown, based on the perceived trajectory 210, the other car 204 would not touch the ego vehicle 202 (as illustrated by 212, showing the other car after some time based on the perceived trajectory 210). However, based on actual trajectory 206, an accident occurs (as illustrated by 208, showing the other car after some time based on actual trajectory 206).

The generated scenario that incorporates $N+1$ vehicles (or road users, wherein N is an integer number) may include or consist of a set $T$ of $N$ multidimensional trajectories $T_i(x_i)$ for i=1.. N, excluding the ego vehicle trajectory which is generated using the to-be-tested control method based on the road situation (or scenario, in other words: based on the trajectories $T_i$). Each trajectory $T_i$ for i=1..N may be described using a vector $x_i$ of n parameters that may be randomly initialized and optimized in a trajectory generation process. The set of all parameters of all trajectories can be denoted as $x$. Trajectories may describe either evolution of spatial coordinates of road users in time or control values (e.g. throttle, steering angle) used to derive the spatiotemporal trajectories.

According to various embodiments, the generated scenario that incorporates $N+1$ vehicles may include or may consist of a set $T$ of $N$ multidimensional state

trajectories $s_i(x_i)$ for i=1...N and a set TE of N perception trajectories $\hat{s}_i(x_i)$ for i=1 ....N, excluding the ego vehicle trajectory which is generated using tested control algorithm based on the road situation. Each trajectory $s_i$ for i=1...N and $\hat{s}_i$ for i=1...N may be described using vector $x_{si}$ of n parameters that can be randomly initialized and optimized in a trajectory generation process. The set of all parameters of all trajectories may be denoted as x. Trajectories may describe either evolution of spatial coordinates of road users in time, or control values (e.g. throttle, steering angle) used to derive the spatio-temporal trajectories, or trajectories of perceived (or observed) actual trajectories.

In order to enforce physical feasibility of the generated trajectories (i.e. the trajectories generated as a solution of the optimization problem), a set of inequality (side) constraints $R_{phys}(x) \geq 0$ may be introduced to the optimization problem. Depending on chosen set of variables controlled by trajectories $T(x)$, this constrain or these constraints may enforce limits imposed on vehicle control values (for example throttle and/ or steering angle) and/ or limits related to an implicit approximation of vehicle dynamic and kinematic limits (for example acceleration and/or velocity and/or spatial trajectory curvature).

For example, the inequality constraints may enforce physical feasibility of the scenarios (for example control limits, or an implicit approximation of vehicle dynamics).

The duration of the optimized trajectories may be either pre-defined or included within parameters vector x (in other words: added ass an additional parameter) and optimized alongside other variables.

According to various embodiments, scenario generation can be performed by solving a following optimization problem:

$$\min_{x} f(x) = \sum_{j=1}^{m} w_j c_j(x)$$

$$\text{subject to} : R_{phys}(x) \geq 0$$

where $c_j$ for j=1..m denotes cost terms (described in next section) weighted by pre-defined weights $w_j$ for j=1..m, and x denotes the vector of parameters which represent the trajectory information.

One or more cost terms may be introduced to obtain useful and realistic scenarios. Each cost term favors maximization of a different measure, as described below: severity of the scenario, plausibility of the scenario, and dissimilarity of the scenario to other scenarios (novelty with regards to generated scenario database). It will be understood that a "cost term" may refer to a term of the cost function.

A severity cost term may measure how dangerous is generated scenario. This term may be handcrafted utilizing measures commonly used in ADAS methods such as time to collision, headway, Euclidean distance between ego vehicle and other road user. Maximization of severity (done e.g. by minimizing weighted sum of mentioned measures for one or more road users at the end of the generated scenario) may ensure that only interesting, high-risk scenarios will be generated, ideally resulting in collisions or at least near-collision conditions.

Alternatively, criticality of generated scenarios may be enforced in more explicit way by adding an inequality constraints that limits lateral and longitudinal distance between the ego vehicle and the other road users to be below 0 at the end of the optimized scenario (so that the trajectory information as a result of the optimization of the optimization problem must end with a collision).

A plausibility term may be introduced to avoid generation of highly improbable scenarios. While it may be relatively easy to find multiple situations in which collision would be unavoidable (e.g. oncoming vehicle from opposite direction lane swerves into ego), usefulness of such scenarios may be relatively low for development and testing of AD/ADAS system. In order to produce more plausible scenarios, behavior of all road users may be evaluated in terms of plausibility and resulting values may be incorporated into the cost function of the optimization problem.

According to various embodiments, plausibility analysis may be performed using a set of rules that penalize implausible behaviors. Penalty rules may be parametrized and optimized in a separate optimization problem to ensure that they reflect real-world probability of occurrence of a given behavior.

An example of a penalized behavior may be that a vehicle driving in a close proximity behind the ego (e.g. longitudinal distance below pi) accelerates towards it (e.g. acceleration above $p_2$). For each time step in which the rule is fulfilled, implausibility penalty may be increased by $p_3$ value. Penalty increase may be proportional to the severity level of a given behavior (e.g. magnitude of acceleration in the described example).

The penalty rules may be evaluated for all of the road users within predefined number of time steps uniformly distributed along generated trajectories and their sum may be minimized to obtain only plausible scenarios.

Values of the parameters $p$ may be optimized based on real world data. By evaluating how often penalized scenarios happen within a large base of trajectories gathered during real world test drives, the optimization problem may be formulated to tune them in such way that the plausibility value computed using all defined rules directly reflects probability of occurrence of given scenario.

Similar to severity, the plausibility measure may also be excluded from the cost function and incorporated in the problem as an inequality constraint. Assuming that plausibility estimation reflects the real world probability of occurrence of given situation reasonably well, this approach may be useful for derivation of SOTIF hazard analysis scenarios as plausibility term directly corresponds to exposure for given scenario that plays important role in SOTIF analysis. Knowing acceptable risk value and corresponding minimal exposure to given scenario, scenarios that have acceptably low probability of occurrence may be discarded by tuning a max value of plausibility inequality constraint.

In order to ensure plausibility of scenario, an additional cost term may be defined to minimize state estimation errors. The cost term can be defined as:

$$c_e = \int_{t=0}^{t_f} ||s(t, \mathbf{x}) - \hat{s}(t, \mathbf{x})|| dt$$

Minimization of the cost term $c_e$ may ensure that state estimation remains close to actual trajectory.

Alternatively, instead of include $c_e$ in cost term, an inequality constraint that limits $c_e$ to a pre-determined acceptable value may be used in the optimization problem.

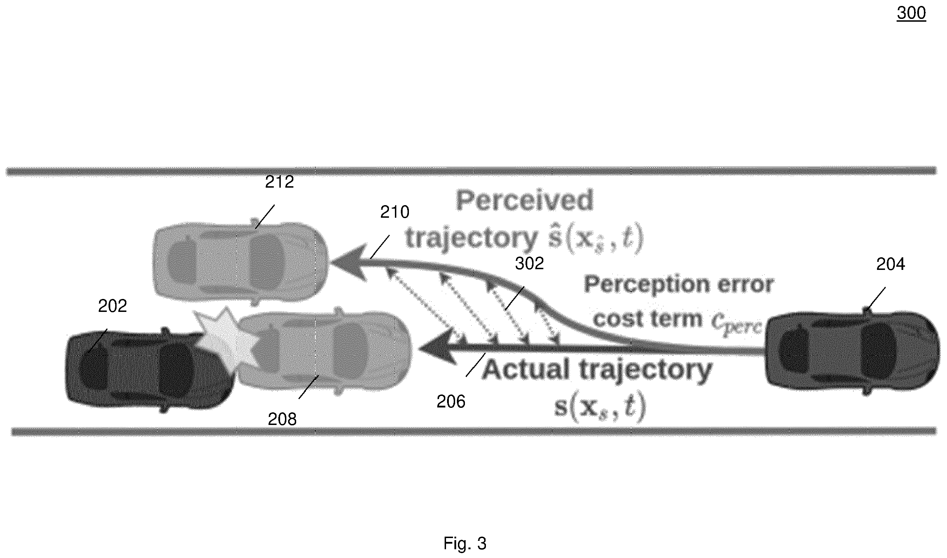

Fig. 3 shows an illustration 300 of a definition of state estimation error according to various embodiments. The perception error cost term 302 may be defined as an integral between the perceived trajectory 210 and the actual trajectory 206 (illustrated by the arrows near 302 in Fig. 3). Minimizing the integral of the error (through cost terms) or limiting the integral of the error to a per-determined value (through inequality constraints) may allow to avoid prolonged severe perception errors and may increase the plausibility of the scenario.

Additional heuristic rules may be introduced to increase plausibility of the generated scenario, e.g.:

- $c_e$ may depend on a distance from the ego vehicle (emulating decreased perception accuracy on long ranges);
- cost of state estimation error may increase with time (emulating advantage that long observation of the object bring in tracking algorithms compared to newly observed object); this can be achieved by multiplying difference between state and state estimate in $c_e$ by t;
- derivatives of state estimations in the perception trajectory may be limited by constraints or penalty terms added to the cost to discourage sudden state change (that are unlikely to occur in tracking/fusion algorithms typically used in perception).

Various cost terms as described herein may be sufficient to generate a single critical scenario. While this ability itself may be useful e.g. for executing iterative improvement process in which each critical scenarios may be addressed and then evaluation will be repeated, it may be desired to generate a larger base of critical scenarios. Thus, a cost term related to novelty within a scenario database may be introduced.

Depending on the optimization method chosen for the execution of the method, multiple scenarios may be obtained by searching for the local optima of the cost function starting from randomized initial guesses. However, this approach may be ineffective in uncovering new critical scenarios, since especially in simpler road situations, optimization problems may tend to always converge to a global optimum or few strong local optima. Thus, when solving the optimization problem several times, even with different initial trajectory data, the result of the optimization (i.e. the trajectory information for which the optimization problem is solved) may be identical.

In order to enable effective repeated usage of method according to various embodiments for finding new critical scenarios, an additional cost term that measures similarity of generated scenario to scenarios generated in previous executions of optimization scheme may be introduced.

The generated scenario may be compared with each of the existing scenarios for instance by evaluating difference in position of each of the road users between generated and existing scenario on each time step. Squared distances may be summed up along the duration of scenario and a sum of resulting values may be used as dissimilarity measure that will be maximized in the optimization process.

Minimization of such a similarity measure may allow to encourage search in configurations poorly covered with trajectories existing in database. Together with randomized initial guesses for exploring different local optima, this approach may allow to generate multiple dissimilar scenarios with denser distribution near most critical parts of the search space.

As described herein, the cost terms related to the state trajectory may promote scenario's severity (e.g., lowest TTC observed during the scenario), plausibility (e.g., negative reward for deliberate, sudden adversary movements near ego) and/or novelty within scenario database (e.g., mean or highest similarity Euclidean distance to other solutions in a parameters space).

As described herein, a method may be provided to automatically generate a large database of plausible critical test scenarios that may for example be utilized in simulation-based testing of ADAS/AD methods. Scenario generation may utilize a model of the tested method in a software-in-loop manner to provide scenarios optimized directly against the tested system. In other words, the optimization process according to various embodiments may be focused on causing collision with a particular tested system. This approach may enable efficient exploration of edge cases, possibly decreasing the necessary amount of expensive end-to-end simulation and road tests.

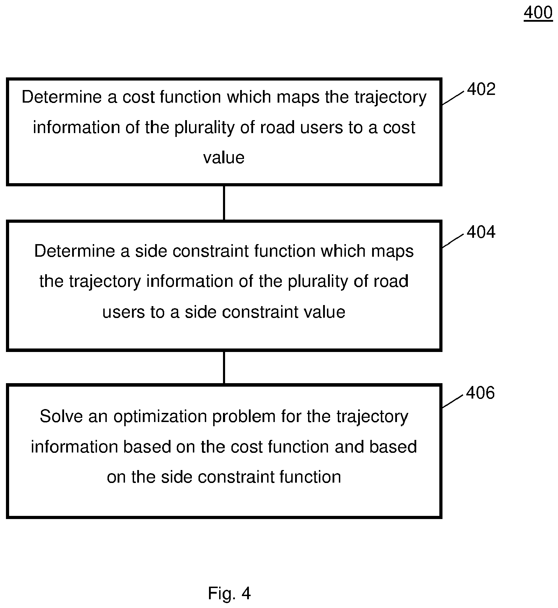

Fig. 4 shows a flow diagram 400 illustrating a method for generating trajectory information of a plurality of road users according to various embodiments. At 402, a cost function which maps the trajectory information of the plurality of road users to a cost value may be determined (for example as pre-defined by a user when setting up the method). At 404, a side constraint function which maps the trajectory information of the plurality of road users to a side constraint value may be determined (for example as pre-defined by a user when setting up the method). At 406, an optimization problem for the trajectory information may be solved based on the cost function and based on the side constraint function. The trajectory information of the plurality of road users may include or may be a plurality of parameters, wherein the plurality of parameters define a respective actual trajectory for each road user of the plurality of road users and a respective observed trajectory for each road user of the plurality of road users. The respective observed trajectory for each road user of the plurality of road users may represent the respective actual trajectory for each road user of the plurality of road users as observed by a sensor. The cost function and/ or the side constraint function may include or may consist of a term based on both the actual trajectory or trajectories for at least one road user of the plurality of road users and the corresponding observed trajectory or trajectories for the at least one road user of the plurality of road users.

According to various embodiments, the optimization problem may be solved iteratively.

According to various embodiments, an initial trajectory information for the optimization problem may be determined randomly.

According to various embodiments, the optimization problem may be solved based on a gradient-free stochastic method, preferably a particle swarm optimization method or a covariance matrix adaptation evolution method.

According to various embodiments, the parameters may further include static environment parameters.

According to various embodiments, the cost function and/ or the side constraint function may be based on a severity of a scenario represented by the trajectory information.

According to various embodiments, the cost function and/ or the side constraint function may be based on a plausibility of a scenario represented by the trajectory information.

According to various embodiments, the cost function and/ or the side constraint function may be based on a novelty of a scenario represented by the trajectory information.

According to various embodiments, the cost function and/ or the side constraint function may include or may be a term related to a desired output of a scenario represented by the trajectory information.

According to various embodiments, the method may further include the following step carried out by the computer hardware components: training a machine-learning model for driving assistance based on the trajectory information.

According to various embodiments, the method may further include the following step carried out by the computer hardware components: testing a machine-learning model for driving assistance based on the trajectory information.

According to various embodiments, the training and/ or the testing may include or may be evaluating a driving policy for an at least partially autonomous vehicle.

According to various embodiments, the driving policy may act based on observed trajectories for the plurality of road users, and the driving policy may be evaluated based on actual trajectories for the plurality of road users.

Each of the steps 402, 404, 406, and the further steps described above may be performed by computer hardware components.

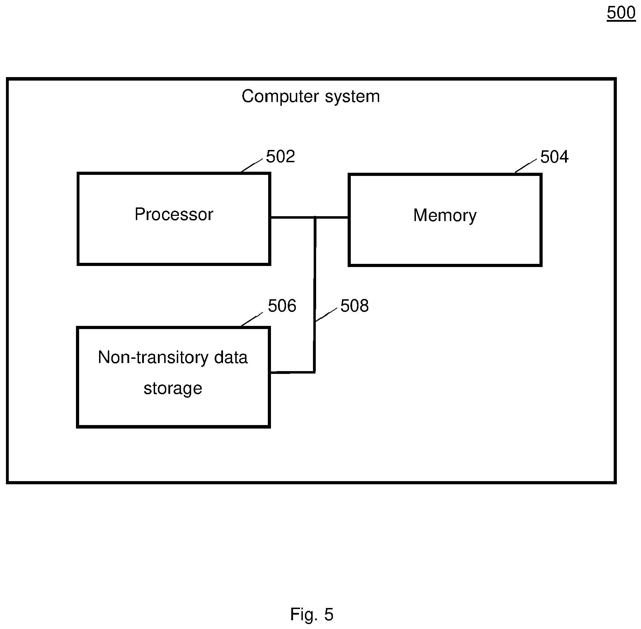

Fig. 5 shows a computer system 500 with a plurality of computer hardware components configured to carry out steps of a computer implemented method for generating trajectory information of a plurality of road users according to various embodiments. The computer system 500 may include a processor 502, a memory 504, and a non-transitory data storage 506.

The processor 502 may carry out instructions provided in the memory 504. The non-transitory data storage 506 may store a computer program, including the instructions that may be transferred to the memory 504 and then executed by the processor 502.

The processor 502, the memory 504, and the non-transitory data storage 506 may be coupled with each other, e.g. via an electrical connection 508, such as e.g. a cable or a computer bus or via any other suitable electrical connection to exchange electrical signals.

The terms "coupling" or "connection" are intended to include a direct "coupling" (for example via a physical link) or direct "connection" as well as an indirect "coupling" or indirect "connection" (for example via a logical link), respectively.

It will be understood that what has been described for one of the methods above may analogously hold true for the computer system 500.

With the methods and systems according to various embodiments, sensor errors critical for the system may be generated, and/or scenarios for training a reinforcement-learning-based driving assistance model may be provided, and/or worst-case scenario analysis for fail-safe planning may be provided, and/or severity of observed real-world scenarios may be increased.

Reference numeral list

100    illustration of a traffic scenario according to various embodiments
102    left lane

104 middle lane
106 right lane
108 ego vehicle
110 first truck
112 trajectory of first truck
114 second truck
116 trajectory of second truck
118 other car
120 trajectory of other car
122 other car after accident

200 illustration of generating an adversarial scenario according to various embodiments
202 ego vehicle
204 other car
206 actual trajectory of other car
208 other car after some time based on actual trajectory
210 perceived trajectory of other car
212 other car after some time based on perceived trajectory

300 illustration of a definition of state estimation error according to various embodiments
302 perception error cost term
400 flow diagram illustrating a method for generating trajectory information of a plurality of road users according to various embodiments
402 step of determining a cost function which maps the trajectory information of the plurality of road users to a cost value
404 step of determining a side constraint function which maps the trajectory information of the plurality of road users to a side constraint value
406 step of solving an optimization problem for the trajectory information based on the cost function and based on the side constraint function

500 computer system according to various embodiments
502 processor
504 memory
506 non-transitory data storage
508 connection

**Claims**

1. Computer implemented method for generating trajectory information of a plurality of road users, the method comprising:

   - determining (402) a cost function which maps the trajectory information of the plurality of road users to a cost value;
   - determining (404) a side constraint function which maps the trajectory information of the plurality of road users to a side constraint value; and

   - solving (406) an optimization problem for the trajectory information based on the cost function and based on the side constraint function;
   - wherein the trajectory information of the plurality of road users comprises a plurality of parameters, wherein the plurality of parameters define a respective actual trajectory for each road user of the plurality of road users and a respective observed trajectory for each road user of the plurality of road users, wherein the respective observed trajectory for each road user of the plurality of road users represents the respective actual trajectory for each road user of the plurality of road users as observed by a sensor; and
   - wherein the cost function and/ or the side constraint function comprises a term based on both the actual trajectory or trajectories for at least one road user of the plurality of road users and the corresponding observed trajectory or trajectories for the at least one road user of the plurality of road users.

2. The computer implemented method according to claim 1,
   wherein the optimization problem is solved iteratively.

3. The computer implemented method according to claim 2,
   wherein an initial trajectory information for the optimization problem is determined randomly.

4. The computer implemented method according to at least one of claims 1 to 3,
   wherein the optimization problem is solved based on a gradient-free stochastic method, preferably a particle swarm optimization method or a covariance matrix adaptation evolution method.

5. The computer implemented method according to at least one of claims 1 to 4,
   wherein the parameters further comprise static environment parameters.

6. The computer implemented method according to at least one of claims 1 to 5,
   wherein the cost function and/ or the side constraint function is based on a severity of a scenario represented by the trajectory information.

7. The computer implemented method according to at least one of claims 1 to 6,
   wherein the cost function and/ or the side constraint function is based on a plausibility of a scenario represented by the trajectory information.

8. The computer implemented method according to at least one of claims 1 to 7,
wherein the cost function and/ or the side constraint function is based on a novelty of a scenario represented by the trajectory information.

9. The computer implemented method according to at least one of claims 1 to 8,
wherein the cost function and/ or the side constraint function comprises a term related to a desired output of a scenario represented by the trajectory information.

10. The computer implemented method according to at least one of claims 1 to 9, further comprising the following step carried out by the computer hardware components:
training a machine-learning model for driving assistance based on the trajectory information.

11. The computer implemented method according to at least one of claims 1 to 10, further comprising the following step carried out by the computer hardware components:
testing a machine-learning model for driving assistance based on the trajectory information.

12. The computer implemented method according to at least one of claims 10 or 11,
wherein the training and/ or the testing comprises evaluating a driving policy for an at least partially autonomous vehicle.

13. The computer implemented method according to claim 12,

    wherein the driving policy acts based on observed trajectories for the plurality of road users; and
    wherein the driving policy is evaluated based on actual trajectories for the plurality of road users.

14. Computer system (500), the computer system (500) being configured to carry out the computer implemented method of at least one of claims 1 to 13.

15. Non-transitory computer readable medium comprising instructions for carrying out the computer implemented method of at least one of claims 1 to 13.

Fig. 1

EP 4 361 877 A1

EP 4 361 877 A1

212

Perceived
trajectory $\hat{s}(\mathbf{x}_{\hat{s}}, t)$

210

202

208   206

204

Actual trajectory
$s(\mathbf{x}_s, t)$

Fig. 2

Perceived trajectory $\hat{s}(x_{\hat{s}}, t)$

Perception error cost term $c_{perc}$

Actual trajectory $s(x_s, t)$

Fig. 3

EP 4 361 877 A1

400

Determine a cost function which maps the trajectory information of the plurality of road users to a cost value /402

Determine a side constraint function which maps the trajectory information of the plurality of road users to a side constraint value /404

Solve an optimization problem for the trajectory information based on the cost function and based on the side constraint function /406

Fig. 4

500

Computer system

Processor 502

Memory 504

Non-transitory data storage 506

508

Fig. 5

Europäisches
Patentamt

European
Patent Office

Office européen
des brevets

**EUROPEAN SEARCH REPORT**

Application Number

EP 22 20 4472

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2022/223816 A1 (FIVE AI LTD [GB]) 27 October 2022 (2022-10-27) * page 22, line 19 - page 24, line 11; claims 1-18; figures 5A-6D * * page 2, lines 13-26 * * page 39, lines 4-6 * | 1-15 | INV. G06F30/20 G06F11/36 |
| A | WO 2022/180241 A1 (FIVE AI LTD [GB]) 1 September 2022 (2022-09-01) * page 1, lines 2-8 * * page 2, lines 25-30 * * page 19, line 16 - page 22, line 29 * | 1-15 | |
| A | WO 2022/162116 A1 (FIVE AI LTD [GB]) 4 August 2022 (2022-08-04) * page 7, line 199 - page 8, line 2 * * page 3, line 26 - page 4, line 96 * | 1-15 | |
| A | US 2022/269279 A1 (REDFORD JOHN [GB] ET AL) 25 August 2022 (2022-08-25) * paragraph [0484] - paragraph [0489] * * paragraph [0494] - paragraph [0515] * | 1-15 | |
| A | US 2022/055663 A1 (BUEHLER ANDREAS [LI] ET AL) 24 February 2022 (2022-02-24) * paragraph [0022] - paragraph [0023] * * paragraph [0054] - paragraph [0057] * | 1-15 | TECHNICAL FIELDS SEARCHED (IPC) G06F G06G B60W G06N |
| A | MICHAEL HOSS ET AL: "A Review of Testing Object-Based Environment Perception for Safe Automated Driving", ARXIV.ORG, CORNELL UNIVERSITY LIBRARY, 201 OLIN LIBRARY CORNELL UNIVERSITY ITHACA, NY 14853, 16 February 2021 (2021-02-16), XP081887389, * page 8, left-hand column - page 9, right-hand column * | 1-15 | |

-/--

The present search report has been drawn up for all claims

| Place of search | Date of completion of the search | Examiner |
|---|---|---|
| Munich | 18 April 2023 | Schneider, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 22 20 4472

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2022/184652 A1 (FIVE AI LTD [GB]) 9 September 2022 (2022-09-09) * page 18, line 19 – page 21, line 2 * ----- | 1-15 | |
| A | ANDREA PIAZZONI ET AL: "Modeling Perception Errors towards Robust Decision Making in Autonomous Vehicles", ARXIV.ORG, CORNELL UNIVERSITY LIBRARY, 201 OLIN LIBRARY CORNELL UNIVERSITY ITHACA, NY 14853, 3 September 2021 (2021-09-03), XP091041992, DOI: 10.24963/IJCAI.2020/483 * the whole document * ----- | 1-15 | |
| A | US 2015/073662 A1 (SCHMÜDDERICH JENS [DE] ET AL) 12 March 2015 (2015-03-12) * paragraph [0046] * * paragraph [0012] * * paragraph [0009] – paragraph [0010] * * paragraph [0113] * * paragraph [0121] – paragraph [0123] * ----- | 1-15 | |
| A | WO 2022/090512 A2 (FIVE AI LTD [GB]) 5 May 2022 (2022-05-05) * claims 14, 15 * ----- | 1-15 | TECHNICAL FIELDS SEARCHED (IPC) |
| A | EP 3 958 181 A1 (FIVE AI LTD [GB]) 23 February 2022 (2022-02-23) * paragraph [0008] * * paragraph [0013] – paragraph [0016] * * paragraph [0048] – paragraph [0049] * * paragraph [0150] – paragraph [0161] * * paragraph [0183] – paragraph [0185] * * paragraph [0312] – paragraph [0316] * * paragraph [0322] – paragraph [0327] * ----- | 1-15 | |

The present search report has been drawn up for all claims

| Place of search | Date of completion of the search | Examiner |
|---|---|---|
| Munich | 18 April 2023 | Schneider, Michael |

EPO FORM 1503 03.82 (P04C01)

page 2 of 2

## ANNEX TO THE EUROPEAN SEARCH REPORT
## ON EUROPEAN PATENT APPLICATION NO.

EP 22 20 4472

This annex lists the patent family members relating to the patent documents cited in the above-mentioned European search report.
The members are as contained in the European Patent Office EDP file on
The European Patent Office is in no way liable for these particulars which are merely given for the purpose of information.

18-04-2023

| Patent document cited in search report | | | Publication date | Patent family member(s) | | | Publication date |
|---|---|---|---|---|---|---|---|
| WO 2022223816 | A1 | | 27-10-2022 | NONE | | | |
| WO 2022180241 | A1 | | 01-09-2022 | NONE | | | |
| WO 2022162116 | A1 | | 04-08-2022 | NONE | | | |
| US 2022269279 | A1 | | 25-08-2022 | CN | 114269620 | A | 01-04-2022 |
| | | | | CN | 114270368 | A | 01-04-2022 |
| | | | | CN | 114270369 | A | 01-04-2022 |
| | | | | CN | 114286773 | A | 05-04-2022 |
| | | | | CN | 114303174 | A | 08-04-2022 |
| | | | | EP | 3789920 | A1 | 10-03-2021 |
| | | | | EP | 4018375 | A1 | 29-06-2022 |
| | | | | EP | 4018376 | A1 | 29-06-2022 |
| | | | | EP | 4018377 | A1 | 29-06-2022 |
| | | | | EP | 4018378 | A1 | 29-06-2022 |
| | | | | EP | 4018379 | A1 | 29-06-2022 |
| | | | | US | 2022269279 | A1 | 25-08-2022 |
| | | | | US | 2022289218 | A1 | 15-09-2022 |
| | | | | US | 2022297707 | A1 | 22-09-2022 |
| | | | | US | 2022297709 | A1 | 22-09-2022 |
| | | | | US | 2022300810 | A1 | 22-09-2022 |
| | | | | WO | 2021037760 | A1 | 04-03-2021 |
| | | | | WO | 2021037761 | A1 | 04-03-2021 |
| | | | | WO | 2021037763 | A1 | 04-03-2021 |
| | | | | WO | 2021037765 | A1 | 04-03-2021 |
| | | | | WO | 2021037766 | A1 | 04-03-2021 |
| US 2022055663 | A1 | | 24-02-2022 | NONE | | | |
| WO 2022184652 | A1 | | 09-09-2022 | NONE | | | |
| US 2015073662 | A1 | | 12-03-2015 | EP | 2845779 | A1 | 11-03-2015 |
| | | | | JP | 6822752 | B2 | 27-01-2021 |
| | | | | JP | 2015051761 | A | 19-03-2015 |
| | | | | US | 2015073662 | A1 | 12-03-2015 |
| WO 2022090512 | A2 | | 05-05-2022 | EP | 4150426 | A2 | 22-03-2023 |
| | | | | WO | 2022090512 | A2 | 05-05-2022 |
| EP 3958181 | A1 | | 23-02-2022 | EP | 3958181 | A1 | 23-02-2022 |
| | | | | WO | 2022038257 | A1 | 24-02-2022 |

EPO FORM P0459

For more details about this annex : see Official Journal of the European Patent Office, No. 12/82